# EUROPÄISCHE PATENTSCHRIFT

(11) **EP 0 472 073 B1**
(45) Veröffentlichungstag und Bekanntmachung des Hinweises auf die Patenterteilung: **05.10.1994**
(21) Anmeldenummer: 91113456.7
(22) Anmeldetag: 10.08.1991
(51) Int. Cl.: G08B 13/24

(54) **Verfahren zur Herstellung von elektrischen Schwingkreisen, insbesondere Resonanz-Etiketten**
Method for producing electric resonant circuits, particularly resonance-tags
Procédé pour la production de circuits électriques résonnantes, en particulier d'étiquettes à résonance

(30) Priorität: 17.08.1990 CH 2685/90
(43) Veröffentlichungstag der Anmeldung: 26.02.1992
(73) Patentinhaber: KOBE PROPERTIES LIMITED, Douglas, Isle of Man, British Isles (GB)
(72) Erfinder: Pichl, Fritz, CH-8802 Kilchberg (CH)
(74) Vertreter: Troesch Scheidegger Werner AG

(56) Entgegenhaltungen:
- EP-A- 0 285 559

## Beschreibung

Die Erfindung betrifft ein Verfahren zur Herstellung von elektrischen Schwingkreisen, insbesondere von Resonanz-Etiketten zur Verwendung in einem Diebstahl-Sicherungssystem, bei welchem eine Spule und ein Kondensator auf ein Dielektrikum aufgebracht jeweils einen Schwingkreis bilden, wobei die Spule in Form einer Spirale und eine Fläche des Kondensators auf der einen Seite und die zweite Fläche des Kondensators auf der anderen Seite des Diekeltrikums angeordnet sind.

Elektrische Schwingkreise dieser Art auf einer Trägerfolie aufgebracht und anschliessend weiter konfektioniert, um als Klebeetiketten oder in Kunststoff-Hartschalen eingebracht in einem Diebstahl-Sicherungssystem verwendet zu werden, wurden bisher meistens mittels eines Ätzverfahrens hergestellt, bei dem das Basismaterial aus zwei durch eine nichtleitende Schicht wie besipielsweise Plastikmaterial getrennten Aluminiumfolien besteht und durch Aufdrucken eines ätzmediumresistenten Lackes auf die beiden Aluminiumfolien die gewünschte Form des aus einer Spule und einem Kondensator bestehenden Schwingkreises festgelegt wird. Wenn durch den Ätzvorgang die unerwünschten Teile der Aluminiumfolie entfernt sind, verbleiben eine Spule in Form einer flächigen Spirale sowie eine erste Kondensatorfläche auf der einen Seite der Trägerfolie und auf der anderen Seite der Trägerfolie entsteht durch den Ätzvorgang eine zweite Kondensatorfläche, die mit der ersten noch elektrisch zu verbinden ist.

Bei der Anwendung einer mit einem solchen Schwingkreis versehenen Resonanz-Etikette in einem Diebstahl-Sicherungssystem wird der Schwingkreis beim Bezahlen der mit der Etikette versehenen Ware an der Kasse deaktiviert oder abgeschaltet, was durch eine Funkenentladung bzw. das Durchbrennen des Kondensators erfolgt. Wenn die Ware nicht bezahlt worden ist, wird beim Passieren eines elektromagnetischen Feldes am Ausgang des Geschäfts ein Stromfluss im Schwingkreis induziert und ein Alarm ausgelöst.

Um das Durchbrennen des Kondensators für die Deaktivierung zu ermöglichen, hat man bisher das Dielektrikum zwischen den beiden Kondensatorflächen in einem bestimmten Bereich verdünnt, wobei eine Verdünnung des Dielektrikums auf etwa 1-3 Mykron notwendig ist, weil sonst ein elektrischer Durchschlag zwischen den beiden Kondensatorflächen nicht erreicht werden kann, da die Stromstärke, die man anwenden kann, wegen der Vorschriften der Post begrenzt ist. Aus Messungen ist bekannt, dass bei einer Dicke des beispielsweise aus Polyäthylen bestehenden Dielektrikums von 25 Mykron für einen elektrischen Durchschlag ca. 500 Volt notwendig sind. Bei einer durch Verdünnung des Dielektrikums erreichten Dicke von 1-3 Mykron sind immerhin noch 5-10 Volt für einen elektrischen Durchschlag notwendig. Die Dicke des Dielektrikums von 1-3 Mykron muss bei der Verdünnung sehr genau eingehalten werden, weil anderenfalls bei einer Unterschreitung es zu einer teilweisen Berührung der Aluminiumflächen des Kondensators kommen kann, sodass durch Kurzschluss der Schwingkreis schon vor seinem Einsatz abgeschaltet ist oder bei sehr dünner Schicht das Mangetfeld im Detektionssystem die Resonanz-Etikette während des Einsatzes deaktiviert. Wenn andererseits die Dicke des Dielektrikums zu gross ist, kann die bei der Kasse von der Abschaltstation erzeugte Stromstärke den Kondensator nicht zum Durchbrennen bringen, sodass eine Deaktivierung nicht möglich ist.

Beim elektrischen Durchschlag entsteht ein feiner Faden aus abgelagertem Aluminiumdampf, der sehr spröde ist. Wenn die Verdünnung des Dielektrikums mittels Werkzeugen unter Anwendung von Druck und/oder Temperatur nicht sehr sorgfältig durchgeführt wurde, können im Dielektrikum im Bereich der Verdünnung Risse oder Kerben entstehen oder das Material des Dielektrikums wird teilweise verdrängt. Der bei der Deaktivierung entstehende Faden aus Aluminium ist dann nicht mehr in dem Material des Dielektrikums eingebettet und gestützt, sondern hängt dann zwischen den beiden Aluminiumflächen im freien Raum und kann bei der geringsten Erschütterung oder Biegung leicht brechen, sodass die Resonanz-Etikette trotz durchgeführter Deaktivierung wieder aktiv ist. Dies hat dann zur Folge, dass ein Kunde trotz Bezahlung seiner Ware an der Kasse beim Passieren des Sicherheitssystems am Ausgang des Geschäfts einen Alarm auslöst und fälschlicherweise angehalten wird, was für alle Beteiligten erhebliche Unannehmlichkeiten mit sich bringt.

Der vorliegenden Erfindung lag daher die Aufgabe zugrunde, Fehlleistungen dieser Art in einem solchen Sicherheitssystem mit elektrischen Schwingkreisen bzw. Resonanz-Etiketten vollkommen auszuschliessen und sicher zu gewährleisten, dass der bei der Deaktivierung durch den elektrischen Durchschlag entstehende Aluminiumfaden niemals brechen kann sondern im Dielektrikum gestützt und eingebettet liegt. Zur Lösung dieser Aufgabe dienen die Massnahmen nach Anspruch 1. Zweckmässige und vorzugsweise angewendete Varianten des Verfahrens ergeben sich aus den abhängigen Ansprüchen.

Um das Verfahren näher zu erläutern, wird zunächst kurz das Verfahren zur Herstellung von elektrischen Schwingkreisen, insbesondere von sogenannten Resonanz-Etiketten anhand einer Zeichnung näher erläutert. Die Funktion des Dielektrikums übernimmt eine Trägerfolie 1, die aus Kunststoffmaterial wie beispielsweise Polypropylen oder Polystyrol oder Polyäthylen besteht. Auf der einen Seite dieser Trägerfolie 1 wird in bekannter Weise eine oder wie im gezeigten Beispiel eine Mehrzahl von neben- und hintereinander angeordneten Spulen in Form einer flächigen Spirale 2 und eine Kondensatorfläche 3 ätztechnisch hergestellt. Zweckmässig kann man bei der Herstellung von einer koextrutierten Aluminiumfolie auf einer Kunststoff-Trägerfolie ausgehen, wobei die Aluminiumfolie in bekannter Weise mit ätzmedienresistentem Lack bedruckt und nach dem Trocknungsprozess des Lackes der unbedruckte Teil der Aluminiumfolie weggeätzt wird. Ausser der Kondensatorfläche 3 am inneren Ende der Spirale 2 wird ausserdem noch an deren äusserem Ende eine kleine Zusatzfläche 4 durch Ätzung hergestellt, die zur elektrischen Verbindung mit der auf der anderen Seite der Trägerfolie aufzubringenden zweiten Kondensatorfläche dient.

Bevor die Trägerfolie 1 die zweite Kondensatorfläche erhält, wird die Trägerfolie 1 zur Lösung der erfindungsgemässen Aufgabe in besonderer Weise behandelt. Die Trägerfolie 1 besitzt eine Dicke von etwa 20-30 µ, was für einen elektrischen Durchschlag eine unzulässig hohe Spannung notwendig machen würde. In der Deaktivierungsstation lassen sich ca. 5-10 Volt induzieren, womit ein elektrischer Durchschlag bei einer Trägerfolie von etwa 2,5 Mykron möglich ist. Daher wird nun erfindungsgemäss in das von der Trägerfolie 1 gebildete Dielektrikum eine Vielzahl von Körpern mit einer Grösse im Mykron-Bereich eingebracht, die bei der funkenartigen Entladung des Kondensators eine elektrisch leitende Verbindung zwischen den Kondensatorflächen entstehen lassen, die dann in Fadenform mindestens weitgehend im Dielektrikum eingebettet ist. Man wählt entweder elektrisch leitfähige Körper wie Kohle, Russ oder Metallpulver oder man verwendet unter der Wirkung der funkenartigen Entladung leitfähig werdende Körper wie beispielsweise Oxyde. Solange der Abstand dieser Körper in dem Dielektrikum nur wenige µ beträgt, findet eine Deaktivierung statt. Ferner ist es ebenso auch möglich, ein Gemisch von Körpern verschiedener chemischer Struktur in das Dielektrikum einzubringen, sodass bei der Funkenentladung eine Reaktion ausgelöst wird, beispielsweise kann man Kupferstaub in das Dielektrikum einbringen, sodass bei der Funkenentladung das Kupfer und das verdampfte Aluminium eine Legierung bilden. Der dann bei der Deaktivierung entstehende Faden ist sehr viel flexibler und zäher als der sehr spröde Faden aus reinem Aluminium.

Für die Einbringung dieser Körper im Mykron-Bereich wählt man in der Trägerfolie 1 eine Zone in Deckungslage zur Kondensatorfläche 3. Das Einbringen dieser Körper erfolgt unter Anwendung von Druck und Temperatur oder die Körper werden unter Druck auf das Dielektrikum aufgeblasen oder sie werden eingewalzt. In jedem Fall wird dabei das Ziel verfolgt, eine möglichst gleichmässige Verteilung dieser Körper im Dielektrikum zu erzielen, wobei der gegenseitige Abstand der Körper 3 µ nicht unterschreiten soll. Einzelne Körper können sich zwar unmittelbar berühren, aber es darf keine leitende Kette von der einen zur anderen Kondensatorfläche entstehen. Beim Einwalzen der Körper und bei Temperaturanwendung erfolgt eine gute Vermischung mit dem zähflüssigen Dielektrikum, welches die Körper umfliesst. Bei allen Verfahrensweisen ist wichtig, dass der bei der späteren Deaktivierung entstehende Faden im Dielektrikum fest eingebettet ist.

Eine weitere Methode für das Einbringen von Körpern mit einer Grösse im Mykron-Bereich in das Dielektrikum besteht darin, dass man die Trägerfolie 1, auf der gemäss Zeichnung eine Vielzahl von Spulen 2 und Kondensatorflächen 3 hergestellt sind, zwischen zwei Elektroden hindurchführt und in dem Moment, in welchem die Elektroden genau über der Kondesatorfläche 3 stehen, einen oder mehrere elektrische Durchschläge erzeugt, und zwar vorzugsweise unter Verwendung einer aus Kupfer bestehenden Elektrode, weil die Kupferpartikel mit den Aluminiumpartikeln im Funkenplasma eine Legierung ergeben. Der Durchschlag erfolgt von der Elektrode auf der Seite des Kondensators durch das Aluminium des Kondensators und durch die aus Pastikmaterial bestehende Trägerfolie zu der anderen Elektrode. Auf diese Weise entsteht mindestens ein oder eine Mehrzahl von elektrisch leitenden Fäden im Dielektrikum.

Die Herstellung der zweiten Kondensatorfläche auf der anderen Seite der Trägerfolie 1 erfolgt vorzugsweise nach einem neuen Verfahren, bei dem darauf verzichtet werden kann, auch die zweite Kondensatorfläche ätztechnisch herzustellen und bei welchem statt dessen bei einer Trägerfolie 1 mit gemäss Zeichnung einer Mehrzahl von hintereinander liegend auf der Trägerfolie angeordneten Spiralen 2 und Kondensatorflächen 3 auf die andere Seite der Trägerfolie 1 ein durchgehender Aluminiumstreifen 5 in Deckungslage bezüglich der ersten Kondensatorfläche 3 und einiger Leiterbahnen der Spirale 2 aufgesiegelt wird. Anschliessend erfolgt dann nur noch die Herstellung einer elektrisch leitenden Verbindung zwischen der Zusatzfläche 4 und dem Aluminiumstreifen 5 durch Crimpen bei 6 und das Durchtrennen des durchgehenden Aluminiumstreifens 5 mit Hilfe von Stanzschnitten 7, damit einzelne Schwingkreise entstehen.

Beim Aufsiegeln des durchgehenden Aluminiumstreifens 5 auf die Trägerfolie 1 kommt es zu einer Verflüssigung des Kunststoffmaterials der Trägerfolie, wobei ein Teil dieses Materials gegen den Rand des Kondensators fliesst. Dadurch werden die zuvor durch die elektrischen Durchschläge entstandenen leitenden Fäden in einzelne Stücke zerbrochen und im Fluss des Kunststoffmaterials gegeneinander verschoben, und zwar mit einem Abstand von 2-3 Mykron. Man erhält dadurch leitende Teilstücke des einen oder mehrerer Fäden, deren Enden wenige Mykron voneinander entfernt sind, wobei das im Prozess des Aufsiegelns flüssige Kunststoffmaterial der Trägerfolie die Teilstücke der Fäden dicht umschliesst. Wenn nun die Deaktivierung des Schwingkreises erfolgen soll, springt der Funke von der Kondensatorfläche entlang der Teilstücke der zuvor erzeugten Fäden zur anderen Kondensatorfläche über. Dabei werden aus der Kondensatorfläche durch den Funken Aluminiumpartikel herausgerissen, die sich im Funkenplasma mit den leitenden Teilstücken verbinden und auf diese Weise einen zähen Faden bilden, der in dem Kunststoffmaterial des Dielektrikums fest eingeschlossen ist. Auf diese Weise ist es ausgeschlossen, dass ein die beiden Aluminiumflächen des Kondensators elektrisch leitend verbindender Faden sich in einem freien Raum befindet und dadurch leicht brechen kann, was zu einer neuen Aktivierung des Schwingkreises führen würde.

Das Einbringen von elektrisch leitenden Teilstücken in das Dielektrikum kann jedoch auch durchgeführt werden, nachdem die zweite Kondensatorfläche auf die Trägerfolie aufgebracht worden ist, d.h. auch bei herkömmlicher Herstellung von Schwingkreisen auf ätztechnischem Weg ist das vorstehend geschilderte Verfahren anwendbar, wobei nicht nur die Funkenentladung sondern auch ein Laserstrahl für das Einbringen von elektrisch leitenden Teilstücken in das Dielektrikum angewendet werden kann. So ist beispielsweise auch eine Abwandlung des Verfahrens in der Weise möglich, dass man auf die Kondensatorfläche eine Schicht eines beliebigen Materials aussen aufbringt und dieses dann durch die Aluminiumfolie hindurch in das Kunststoffmaterial des Dielektrikums und zwar durch Funkenentladung oder mittels eines Laserstrahls einbringt. Daran schliesst sich dann wenn notwendig ein Walkprozess unter Anwendung von Druck und Temperatur an, um Teilstücke des Fadens im Material des Dielektrikums fest einzubetten.

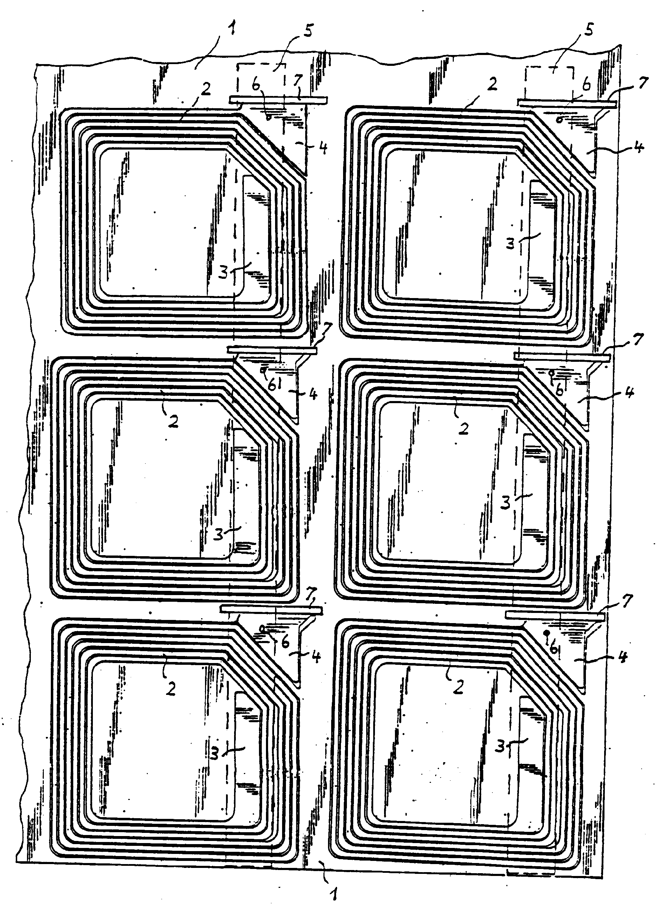

## Patentansprüche

1. Verfahren zur Herstellung von elektrischen Schwingkreisen, insbesondere Resonanz-Etiketten zur Verwendung in einem Diebstahl-Sicherungssystem, bei welchem eine Spule und ein Kondensator auf ein Dielektrikum aufgebracht jeweils einen Schwingkreis bilden, wobei die Spule in Form einer Spirale und eine Fläche des Kondensators auf der einen Seite und die zweite Fläche des Kondensators auf der anderen Seite des Dielektrikums angeordnet sind, dadurch gekennzeichnet, dass zwecks späterer Deaktivierung des Schwingkreises durch funkenartige Entladung des Kondensators in das Dielektrikum eine Vielzahl von Körpern mit einer Grösse im Mykron-Bereich eingebracht wird, die bei der funkenartigen Entladung des Kondensators zwischen dessen Flächen eine elektrisch leitende Verbindung entstehen lassen, die in Fadenform mindestens weitgehend im Dielektrikum eingebettet ist.

2. Verfahren nach Anspruch 1, dadurch gekennzeichnet, dass eine Vielzahl von Körpern mit einer Grösse im Mykron-Bereich in das Dielektrikum eingebracht werden, die entweder elektrisch leitfähig oder unter der Einwirkung der funkenartigen Entladung leitfähig werden.

3. Verfahren nach Anspruch 2, dadurch gekennzeichnet, dass ein Gemisch von Körpern verschiedener chemischer Struktur in das Dielektrikum eingebracht wird, bei dem durch die Funkenentladung eine Reaktion, insbesondere eine chemische Reaktion, ausgelöst wird.

4. Verfahren nach Anspruch 3, dadurch gekennzeichnet, dass eine Vielzahl von Körpern im Mykron-Bereich, beispielsweise Kupferstaub in das Dielektrikum eingebracht wird, wodurch bei der Funkenentladung mit dem verdampften Aluminium der Kondensatorflächen eine Legierung mit grösserer Zähigkeit als reines Aluminium entsteht.

5. Verfahren nach einem der Ansprüche 1-4, dadurch gekennzeichnet, dass die Körper unter Anwendung von Druck und Temepratur in das Dielektrikum eingewalzt oder mittels Druck aufgeblasen werden.

6. Verfahren nach Anspruch 1, dadurch gekennzeichnet, dass das aus der Trägerfolie bestehende Dielektrikum mit auf einer Seite der Trägerfolie aus einer auf dieser befindlichen Aluminiumfolie durch Ätzverfahren hergestellten Spule und einer Kondensatorfläche zwischen zwei Elektroden,vorzugsweise aus Kupfer,hindurch bewegt wird und elektrische Durchschläge zwischen den Elektroden erzeugt werden, welche ausgehend von der Kondensatorfläche mindestens einen aus einer Legierung aus verdampftem Aluminium- und Kupferpartikeln bestehenden elektrisch leitenden Faden in der Trägerfolie entstehen lassen, und dass anschliessend auf die andere Seite der Trägerfolie ein Aluminiumstreifen als zweite Kondensatorfläche unter Druckanwendung und teilweiser Verflüssigung des Trägerfolienmaterials aufgesiegelt und dabei der elektrisch leitende Faden in Teilstücke zerbrochen wird, wobei diese im Mykron-Bereich gegeneinander verschoben im Trägerfolienmaterial eingebettet werden und einen unterbrochenen Leiter im Dielektrikum für die spätere Funkenübertragung bei der Deaktivierung bilden.

7. Verfahren nach einem der vorhergehenden Ansprüche, dadurch gekennzeichnet, dass aus einer auf die auf dem Dielektrikum vorhandenen Kondensatorfläche aufgebrachten Materialschicht Körper dieses Materials mit einer Grösse im Mykron-Bereich zwecks Bildung eines fadenförmigen Leiters mittels Funkenentladung oder mittels Laserstrahl in das Dielektrikum eingebracht werden und der Leiter anschliessend in Teilstücke zerbrochen wird.

## Claims

1. A process for the production of electrical resonant circuits, especially resonance tags for use in a theft protection system, in which a coil and a capacitor mounted on a dielectric form a resonant circuit, the coil being arranged in the shape of a spiral and one surface of the capacitor being arranged on one side of the dielectric and the second surface of the capacitor being arranged on the other side of the dielectric, **characterised in that** for the purpose of later deactivation of the resonant circuit by spark-like discharge of the capacitor there is incorporated into the dielectric a large number of bodies of a size in the micron range which, when the spark-like discharge of the capacitor occurs, cause an electrically conductive connection to be made between the surfaces of the capacitor, which connection, in a thread shape, is at least substantially embedded in the dielectric.

2. A process according to claim 1, **characterised in that** a large number of bodies of a size in the micron range is incorporated into the dielectric, which bodies are either electrically conductive or become conductive under the action of the spark-like discharge.

3. A process according to claim 2, **characterised in that** a mixture of bodies of different chemical structure is incorporated into the dielectric, in which a reaction, especially a chemical reaction, is triggered by the spark discharge.

4. A process according to claim 3, **characterised in that** a large number of bodies in the micron range, for example copper powder, is incorporated into the dielectric, so that when the spark discharge occurs there is formed with the vaporised aluminium of the capacitor surfaces an alloy having greater ductility than does pure aluminium.

5. A process according to any one of claims 1 to 4, **characterised in that** the bodies are incorporated into the dielectric by rolling under the application of pressure and heat or are applied by blowing using pressure.

6. A process according to claim 1, **characterised in that** the dielectric consisting of the carrier foil, having on one side of the carrier foil the coil produced by an etching process from an aluminium foil located on the carrier foil, and a capacitor surface, is moved between two electrodes, preferably of copper, and electrical discharges are generated between the electrodes, which discharges starting from the capacitor surface cause the formation in the carrier foil of at least one electrically conductive thread consisting of an alloy of vaporised aluminium and copper particles, and then an aluminium strip, as the second capacitor surface, is sealed onto the other side of the carrier foil under the application of pressure and with partial fluidisation of the carrier foil material and at the same time the electrically conductive thread is broken into fragments, those fragments, spaced apart from one another by amounts in the micron range, being embedded in the carrier foil material and forming a broken conductor in the dielectric for later spark transmission on deactivation.

7. A process according to any one of the preceding claims, **characterised in that** from a layer of material applied to the capacitor surface present on the dielectric, bodies of that material of a size in the micron range are incorporated into the dielectric by means of spark discharge or by means of a laser beam for the purpose of forming a thread-shaped conductor and the conductor is then broken into fragments.

## Revendications

1. Procédé pour la fabrication de circuits électriques résonnants, en particulier d'étiquettes à résonnance destinées à une utilisation dans un système d'alarme antivol, dans lequel une bobine et un condensateur posé sur un diélectrique forment chacun un circuit résonnant, la bobine se présentant sous la forme d'une spirale et la première face du condensateur étant disposée sur la première face du diélectrique et la seconde face du condensateur sur l'autre face du diélectrique, caractérisé en ce que, dans le but de désactiver ultérieurement le circuit résonnant par décharge à étincelles du condensateur dans le diélectrique, un grand nombre de corps, dont la taille est de l'ordre de grandeur du micron, est incorporé dans le diélectrique, lesquels permettent, au moment de sa décharge à étincelles, l'établissement d'une liaison électrique conductrice qui, sous la forme d'un fil, est au moins largement incorporée dans le diélectrique.

2. Procédé selon la revendication 1, caractérisé en ce qu'un grand nombre de corps, dont la taille est de l'ordre de grandeur du micron, est incorporé dans le diélectrique, ces corps étant des conducteurs électriques ou devenant conducteurs sous l'effet de la décharge à étincelles.

3. Procédé selon la revendication 2, caractérisé en ce qu'un mélange de corps de structures chimiques différentes est incorporé dans le diélectrique, dans lequel une réaction, notamment une réaction chimique, est déclenchée par la décharge à étincelles.

4. Procédé selon la revendication 3, caractérisé en ce qu'un grand nombre de corps de l'ordre de grandeur du micron, par exemple de la poussière de cuivre, est incorporé dans le diélectrique, un alliage de plus grande ténacité que l'aluminium pur se formant, lors de la décharge à étincelles, avec la vapeur d'aluminium provenant des faces du condensateur.

5. Procédé selon l'une quelconque des revendications 1 à 4, caractérisé en ce que les corps sont pressés dans le diélectrique sous l'effet de la pression et de la température, ou bien y sont injectés sous pression.

6. Procédé selon la revendication 1, caractérisé en ce que le diélectrique constitué de la plaque support, avec sur une face de la plaque support une bobine, fabriquée par attaque chimique de la feuille d'aluminium s'y trouvant, et une surface de condensateur, est déplacé entre deux électrodes, de préférence en cuivre, entre lesquelles sont produites des décharges électriques qui conduisent à la formation, à partir de la face du condensateur, d'au moins un fil conducteur électrique constitué d'un alliage de vapeurs d'aluminium et de particules de cuivre, et en ce qu'ensuite on scelle sur l'autre face de la plaque support une bande d'aluminium, en agissant sous pression et par liquéfaction partielle du matériau de la plaque support, le fil conducteur électrique se brisant alors en morceaux, lesquels sont incorporés dans le matériau de la plaque support et sont espacés les uns des autres de l'ordre du micron, ce qui forme un conducteur discontinu dans le diélectrique pour la transmission ultérieure des étincelles lors de la désactivation.

7. Procédé selon l'une des revendications précédentes, caractérisé en ce que, à partir d'une couche de matière déposée sur la face de condensateur présente sur le diélectrique, des corps constitués dans ce matériau, d'une taille de l'ordre du micron, sont incorporés dans le diélectrique au moyen d'une décharge à étincelles ou d'un rayon laser, pour former un conducteur en forme de fil, ce conducteur étant ensuite brisé en morceaux.
